(19) Europäisches Patentamt
European Patent Office
Office européen des brevets

(11) **EP 0 582 279 B1**

(12) **EUROPÄISCHE PATENTSCHRIFT**

(45) Veröffentlichungstag und Bekanntmachung des Hinweises auf die Patenterteilung:
**10.09.1997   Patentblatt 1997/37**

(51) Int Cl.6: **G01N 27/22**

(21) Anmeldenummer: **93112451.5**

(22) Anmeldetag: **04.08.1993**

(54) **Schaltungsanordnung zur Auswertung des Signales eines kapazitiven Messfühlers**

Circuit for exploiting the signal of a capacitive sensor

Circuit d'exploitation du signal d'un capteur capacitif

(84) Benannte Vertragsstaaten:
**AT BE CH DE DK FR GB IT LI NL SE**

(30) Priorität: **07.08.1992  DE 4226137**

(43) Veröffentlichungstag der Anmeldung:
**09.02.1994   Patentblatt 1994/06**

(73) Patentinhaber: **HONEYWELL AG**
**63067 Offenbach (DE)**

(72) Erfinder:
• **Scheler, Bernd**
**D-63619 Bad Orb (DE)**
• **Ehlers, Dieter**
**D-63165 Mühlheim (DE)**

(74) Vertreter: **Herzbach, Dieter, Dipl.-Ing. et al**
**Honeywell Holding AG**
**Patent- und Lizenzabteilung**
**Postfach 10 08 65**
**63008 Offenbach (DE)**

(56) Entgegenhaltungen:
**EP-B- 0 106 345          BE-A- 901 613**
**DE-A- 3 146 492          DE-C- 3 521 974**
**US-A- 4 657 039**

• **IEEE TRANSACTIONS ON INSTRUMENTATION AND MEASUREMENT Bd. 39, Nr. 3, Juni 1990, NEW YORK US Seiten 508 - 511 D. D. DENTON ET AL. 'A Solid-State Relative Humidity Measurement System'**
• **ELEKTOR Bd. 72, April 1981, CANTERBURY GB Seiten 419 - 421 'Humidity sensor'**

Bemerkungen:
Die Akte enthält technische Angaben, die nach dem Eingang der Anmeldung eingereicht wurden und die nicht in dieser Patentschrift enthalten sind.

**Beschreibung**

Die vorliegende Erfindung bezieht sich auf eine Schaltungsanordnung nach dem Gattungsbegriff des Patentanspruches 1.

Eine derartige Schaltungsanordnung ist aus der BE-A-901 613 bekannt.

Eine weitere Schaltungsanordnung ist aus dem VALVO-Bericht 790423, technische Information "Sensor zur Messung der relativen Luftfeuchte" bekannt. Die dort dargestellte und beschriebene Prinzipschaltung verwendet zwei Multivibratoren, wobei die Dauer der Rechteckimpulse des einen Multivibrators der Kapazität eines Referenzkondensators proportional ist. Diese Rechteckimpulse werden benutzt, um die Rechteckschwingungen des zweiten Multivibrators zu synchronisieren, dessen Impulsdauer der Kapazität des Meßfühlers proportional ist. Die Ausgangsimpulse beider Multivibratoren werden logisch verknüpft, so daß sich eine resultierende Impulsdauer ergibt, die der Differenz der Impulsdauer beider Multivibratoren entspricht.

Ferner ist aus der EP-B1-0 106 345 eine Schaltungsanordnung bekannt, bei der in den kreuzgekoppelten Zweigen eines einzigen Multivibrators ein kapazitiver Meßwertfühler $C_{sens}$ und ein Referenzkondensator $C_{ref}$ angeordnet sind und die beiden Ausgangssignale des Multivibrators über mittelwertbildende Glieder den beiden Eingängen eines Differenzverstärkers zugeführt sind. Der Differenzverstärker liefert hierbei ein Ausgangssignal gemäß folgender Beziehung:

$$U_A = K \cdot \frac{C_{sens} - C_{ref}}{C_{sens} + C_{ref}}$$

Eine solche Ausgangsspannung zeigt selbst bei einem linearen Meßwertfühler einen progressiven Verlauf. Darüber hinaus ist eine unabhängige Offset-Subtraktion an dem Differenzverstärker nicht möglich, da beide Eingänge des Differenzverstärkers mit den Ausgängen des Multivibrators beschaltet sind.

Ausgehend von dem eingangs genannten Stand der Technik ist es daher die Aufgabe der vorliegenden Erfindung, eine Schaltungsanordnung anzugeben, die einfach aufgebaut ist, einfach auch mit extern angeordnetem Potentiometer zu eichen ist und bei der auf einfache Weise Toleranzen des Meßwertfühlers ausgeglichen werden können. Die Lösung dieser Aufgabe gelingt gemäß den kennzeichnenden Merkmalen des Patentanspruches 1. Weitere vorteilhafte Ausgestaltungen der erfindungsgemäßen Schaltungsanordnung sind den abhängigen Unteransprüchen entnehmbar.

Anhand eines in den Figuren der beiliegenden Zeichnung dargestellten Ausführungsbeispieles sei im folgenden die Schaltungsanordnung gemäß der Erfindung näher erläutert. Es zeigen:

Fig. 1            den prinzipiellen Aufbau der erfin dungsgemäßen Schaltungsanordnung;

Fig. 2a bis 2d     Signalverläufe innerhalb der Schaltungsanordnung nach Fig. 1; und

Fig. 3            die Schaltungsanordnung nach Fig. 1 in näheren Einzelheiten.

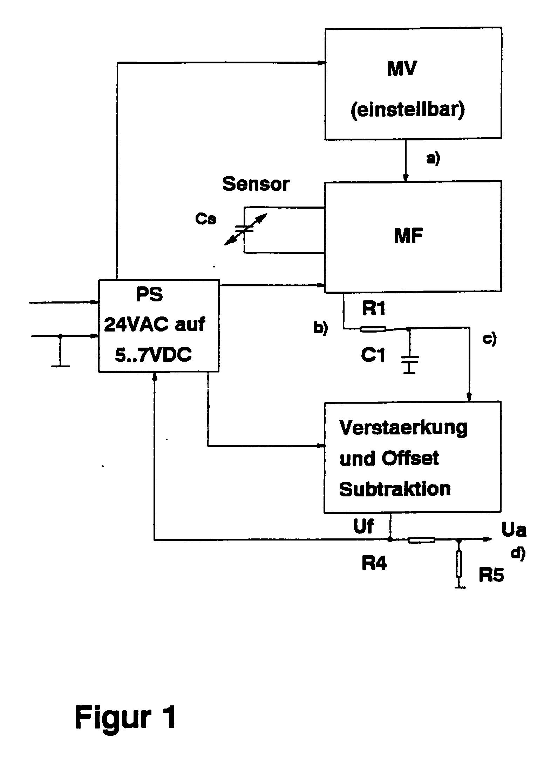

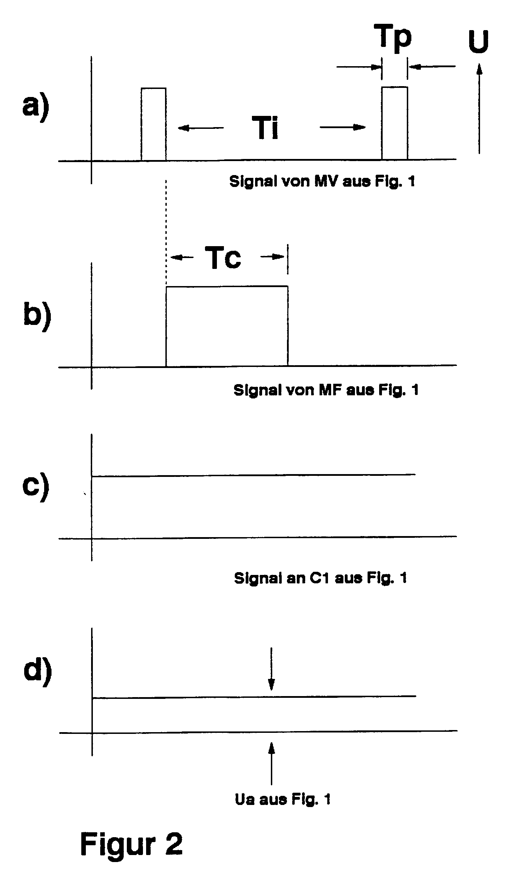

Gemäß Fig. 1 ist ein Multivibrator MV angeordnet, der eine vorgebbare Frequenz erzeugt, wobei die Impulse eine Dauer Tp und die Impulspause eine Dauer Ti aufweisen. Hierbei ist der Multivibrator MV so dimensioniert, daß die Impulspause Ti sehr viel größer als die Impulsdauer Tp ist. Mit der abfallenden Flanke des Impulses Tp wird ein Monoflop MF getriggert, welches einen Ausgangsimpuls der Länge Tc erzeugt, wobei diese Ausgangsimpulslänge der Kapazität des kapazitiven Meßwertfühlers $C_s$ direkt proportional ist, da dieser das zeitbestimmende Element des Monoflops MF ist. Die Frequenz des Multivibrators MV ist einstellbar, beispielsweise zwischen 50 und 200 kHz, um den hohen Toleranzen des kapazitiven Meßwertfühlers (+/-20%) durch eine entsprechende Einstellung der Frequenz Rechnung zu tragen. Diese Frequenzeinstellung kann auch aus der Ferne erfolgen, was von Vorteil ist, wenn z.B. die eigentliche Sensorschaltung aus Multivibrator und Monoflop am Meßort, z. B. in einem Luftkanal und die Auswerteschaltung und Spannungsversorgung an einem hiervon entfernten Ort, z. B. in einer Anschlußdose außerhalb des Luftkanals angeordnet sind.

Die Ausgangsimpulse des Monoflops MF werden einem Integrierglied R1, C1 zugeführt, welches die Impulse Tc mittelt und eine Spannung liefert, die folgender Beziehung Tc/(Ti+Tp) proportional ist.

Ein Verstärkungs- und Offsetsubtraktions-Schaltkreis ist angeordnet, um von der an dem Kondensator C1 anstehenden Spannung einen festen Wert, beispielsweise den Wert, den der kapazitive Meßwertfühler bei 0% relativer Feuchte aufweist, abzuziehen. Der abzuziehende Wert bestimmt die Verstärkung des Schaltkreises und er kann so vorgegeben werden, daß z.B. bei 0% relativer Feuchte das Ausgangssignal des Schaltkreises 0 Volt beträgt. Eine Normierung der Ausgangsspannung (0 bis 1V) über den Meßbereich (0% bis 100% relative Feuchte) des Meßwertfühlers und eine Anpassung der Ausgangsimpedanz (500 Ω) kann über die Teilerwiderstände R4 und R5 vorgegeben werden.

Mit dem Ausgangssignal des Verstärkungs- und Offsetsubtraktions-Schaltkreises kann die Spannung einer Spannungsversorgungsquelle PS nachgeführt werden, um das nichtlineare Verhalten des Meßwertfühlers Cs zu kompensieren. Die Spannungsversorgungsquelle PS bildet aus einer 24V Wechselspannung eine 5V Gleichspannung. Mit dem Ausgangssignal des Verstärkungs- und Offsetsubtraktions-Schaltkreises kann diese Versorgungs-Gleichspannung im genannten Beispiel von 5V auf 7V über den Meßbereich angehoben werden, um hierdurch einer degressiven Kennlinie des Meßwertfühlers Rechnung zu tragen.

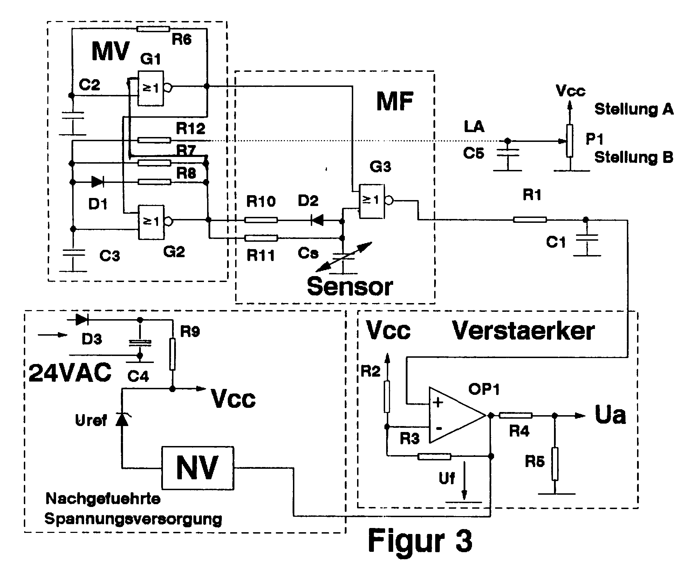

Fig. 3 zeigt nähere Einzelheiten des Schaltkreises gemäß Fig. 1. Der Multivibrator MV besteht aus zwei CMOS-NOR-Bausteinen G1 und G2, in deren kreuzgekoppelten Zweigen RC-Glieder angeordnet sind, durch deren Zeitkonstanten die Impulsdauer Tp und die Impulspause Ti einstellbar sind. Als Kondensatoren C2 und C3 werden NPO-Kondensatoren verwendet, die sehr alterungsbeständig und temperaturunabhängig sind. über einen einstellbaren Widerstand P1 kann die Impulspause Ti und damit die Frequenz des Multivibrators MV verändert werden. Dies ist erforderlich, da der eigentliche Sensor, nämlich das mit dem kapazitiven Meßwertfühler Cs beschaltete Monoflop MF, welches ebenfalls durch einen CMOS-NOR-Baustein G3 realisiert ist, ein Signal Tc liefert, das durch die Toleranz (±20%) des Meßwertfühlers beeinflußt wird. über die einstellbare Frequenz des Multivibrators MV kann man jeden Fühler eichen, so daß er bei gleichem Meßwert (relative Feuchtigkeit) das gleiche Ausgangssignal liefert. Die Impulsdauer Tc erfährt zwar eine Änderung auf Grund der Toleranz des kapazitiven Meßwertfühlers (Cs); durch Änderung der Abstände der Impulse Tc in Folge Frequenzänderung des Multivibrators MV wird jedoch der durch das nachgeschaltete Integrierglied R1, C1 gebildete Wert so eingestellt, daß er bei gleicher Meßgröße den gleichen Wert aufweist. Der Wert Tc/(Ti+Tp) ist somit für jeden Sensor bei gleichem Meßwert der gleiche.

Die über dem Kondensator C1 des Integriergliedes R1, C1 anstehende Meßspannung wird dem einen Eingang eines Operationsverstärkers OP1 zugeführt. Der andere Eingang des Operationsverstärkers OP1 ist über einen Widerstand R2 an die Versorgungsgleichspannung $V_{cc}$ gelegt bzw. über einen Widerstand R3 mit seinem Ausgang verbunden. Durch Dimensionierung der Widerstände R2, R3 läßt sich eine Offset-Subtraktion vorgeben, durch die beispielsweise einem Wert von 0% relativer Feuchtigkeit ein Ausgangssignal von 0 Volt zugeordnet wird. Die Widerstände R4, R5 am Ausgang des Operationsverstärkers OP1 dienen - wie erwähnt - der Normierung (0 - 1V) des Meßsignales und der Anpassung der Ausgangsimpedanz.

Die Schaltung wird von einer variablen Spannung Vcc, die von der Spannung Uref an einer Zenerdiode abgeleitet wird, versorgt. Diese Zenerdiode wird über den Widerstand R9 aus dem Speicherkondensator C4 gespeist, welcher über die Gleichrichterdiode D3 aus einer 24V Wechselspannungsquelle geladen wird. Der Fusspunkt (Anode) der Zenerdiode wird vom Ausgang des Operationsverstärkers OP1 über den Nachverstärker NV gesteuert. Vcc ergibt sich dadurch zu Vcc=Uf*n+Uref mit n = Verstärkungsgrad von NV.

Das Maß (n), um das die Versorgungsspannung Vcc angehoben werden muß, hängt davon ab, wie stark degressiv die Sensorkennlinie ist und wie der Signalgewinn der Schaltung dimensioniert ist (Der Signalgewinn ist proportional zu Tc/Tp+Ti). Hierdurch wird eine degressive Kennlinie des kapazitiven Meßwertfühlers Cs linearisiert. Die so gebildete Versorgungs-Gleichspannung Vcc wird als Speisespannung allen Komponenten MV, G1, G2 MF, G3 und OP1 der Schaltungsanordnung zugeführt.

Die Frequenzeinstellung des Multivibrators MV mit dem Potentiometer P1 geschieht wie folgt: Während der Impulspause Ti wird der Kondensator C3 über den Widerstand R7 geladen. AmEnde von Ti hat die Spannung am Kondensator C3 die Schaltschwelle des Gatters G2 erreicht. Die Anordnung schaltet um.

In Abhängigkeit von der Stellung des Potentiometers P1 wird der Ladevorgang des Kondensators C3 beschleunigt oder verlangsamt. In Stellung A wird die Aufladung des Kondensators C3 über den Widerstand R12 aus Vcc beschleunigt, in Stellung B verlangsamt. Durch Einschalten des Kondensators C5 bleibt die Kapazität der Leitung ohne meßbaren Einfluß. Das Potentiometer P1 und der Kondensator stellen eine variable Gleichspannungsquelle mit relativ geringem Innenwiderstand für hohe Frequenzen dar, sofern C5 groß gegenüber der Leitungskapazität ist. Die Einstellung kann somit auch von Ferne erfolgen.

**Patentansprüche**

1. Schaltungsanordnung zur Auswertung des Signales eines kapazitiven Meßwertfühlers ($C_s$), insbesondere eines Feuchtefühlers, mit einem Multivibrator (MV) zur Vorgabe einer vom Meßwert unabhängigen, aber einstellbaren Frequenz, mit einem von dem Multivibrator periodisch getriggerten Monoflop (MF), dessen Schaltverhalten von dem kapazitiven Meßwertfühler ($C_s$) beeinflußt wird und mit einem an das Monoflop (MF) angeschlossenen Integrierglied (R1, C1), dessen Signal dem einen Eingang eines Differenzverstärkers (OP1) zugeführt wird, dessen anderem Eingang eine einstellbare Spannung zugeführt wird, die dem von dem Meßwertfühler bei einem Referenzwert gebildeten Meßwert entspricht, wobei die den Multivibrator und das Monoflop umfassende Meßschaltung von der den Differenzverstärker umfassenden Auswerteschaltung entfernt angeordnet und über eine Meßleitung verbunden ist, **dadurch gekennzeichnet,** daß zur Frequenzeinstellung des Multivibrators (MV) ein Kondensator (C3) des Multivibrators über eine Leitung (LA) an ein entfernt angeordnetes Potentiometer (P1) angeschlossen ist und ein Kondensator (C5) zwischen die Leitung (LA) und Masse geschaltet ist, um den Einfluß der Leitung (LA) zu minimieren.

## Claims

1. Circuit device for exploiting the signal of a capacitive measuring sensor (Cs), in particular of a humidity sensor, comprising a multivibrator (MV) for delivering a frequency independent of the measuring value, but being adjustable, a monoflop (MF) periodically triggered by the multivibrator, the switching behaviour of which is influenced by the capacitive measuring sensor ($C_s$), and an integrating circuit (R1, C1) connected to said monoflop (MF), the signal of which is fed to one input of a differential amplifier (OP1) having fed to its other input an adjustable voltage, which corresponds to the measured value formed by the measuring sensor at a reference value, whereat the measuring circuit formed by the multivibrator and the monoflop is remotely arranged from the exploitation circuit comprising the differential amplifier and is connected via a measuring line, **characterized in that** for adjusting the frequency of the multivibrator (MV) a capacitor (C3) of the multivibrator is connected to a remotely arranged potentiometer (P1) via a line (LA) and that a capacitor (C5) is connected between said line (LA) and ground, in order to minimize the influence of said line (LA).

## Revendications

1. Montage pour exploiter le signal d'un capteur de mesure capacitif (CS), notamment d'un capteur d'humidité, comportant un multivibrateur (MV) servant à pré-établir une fréquence indépendante de la valeur de mesure, mais réglable, une bascule monostable (MF) déclenchée périodiquement par le multivibrateur et dont le comportement de commutation est influencé par le capteur de mesure capacitif (CS), et un circuit intégrateur (R1,C1), qui est raccordé à la bascule monostable (MF) et dont le signal est envoyé à l'une des entrées d'un amplificateur différentiel (OP1), à l'autre entrée duquel est envoyée une tension réglable, qui correspond à la valeur de mesure formée par le capteur de mesure pour une valeur de référence, le circuit de mesure qui comprend le multivibrateur et la bascule monostable étant disposé dans une position éloignée du circuit d'exploitation comprenant l'amplificateur différentiel, et étant relié par une ligne de mesure, caractérisé en ce que pour le réglage de fréquence du multivibrateur (MV), un condensateur (C3) du multivibrateur est raccordé, par l'intermédiaire d'une ligne (LA), à un potentiomètre (P1) disposé à distance et un condensateur (C5) est branché entre la ligne (LA) et la masse de manière à réduire à un minimum l'influence de la ligne (LA).

## Figur 1

a) Signal von MV aus Fig. 1

b) Signal von MF aus Fig. 1

c) Signal an C1 aus Fig. 1

d) Ua aus Fig. 1

# Figur 2

**Figur 3**

EP 0 582 279 B1